# EUROPÄISCHE PATENTSCHRIFT

(11) **EP 2 115 092 B1**
(45) Veröffentlichungstag und Bekanntmachung des Hinweises auf die Patenterteilung: **04.05.2011**
(21) Anmeldenummer: 08707688.1
(22) Anmeldetag: 13.02.2008
(51) Int. Cl.: C09K 11/80

(54) **LEUCHTSTOFFE BESTEHEND AUS DOTIERTEN GRANATEN FÜR PCLEDS**
LUMINOPHORES MADE OF DOPED GARNETS FOR PCLEDS
SUBSTANCES LUMINESCENTES CONSTITUÉES DE GRENATS DOPÉS POUR DES DEL À CONVERSION PAR LUMINOPHORE

(30) Priorität: 06.03.2007 DE 102007010719
(43) Veröffentlichungstag der Anmeldung: 11.11.2009
(73) Patentinhaber: Merck Patent GmbH, 64293 Darmstadt (DE)
(72) Erfinder: WINKLER, Holger, 64291 Darmstadt (DE); VOSGROENE, Tim, 64372 Ober-Ramstadt (DE); JUESTEL, Thomas, 58455 Witten (DE); MOELLER, Stephanie, 48565 Steinfurt (DE)
(86) Internationale Anmeldenummer: PCT/EP2008/001074
(87) Internationale Veröffentlichungsnummer: WO 2008/107062

(56) Entgegenhaltungen:
- WO-A-2004/055910
- WO-A-2006/006099
- DE-A1- 10 202 741

## Beschreibung

Die Erfindung betrifft Leuchtstoffe, die aus mit Th⁴⁺, Sb³⁺, und/oder Bi³⁺-codotierten Granaten bestehen, deren Herstellung sowie deren Verwendung als LED-Konversionsleuchtstoff für weiße LEDs oder sogenannte Color-on-demand-Anwendungen.

Unter dem Color-on-demand Konzept versteht man die Realisierung von Licht eines bestimmten Farbpunktes mit einer pcLED (=phosphor converted LED) unter Einsatz eines oder mehrer Leuchtstoffe. Dieses Konzept wird z.B. verwendet, um bestimmte Corporate Designs z.B. für beleuchtete Firmenlogos, Marken etc. zu erzeugen.

Übliche Leuchtstoffe mit Granatstruktur, wie reines YAG:Ce oder Derivate davon zeigen bei Verwendung insbesondere in high power LEDs nicht optimale spektroskopische Eigenschaften. Die Ursachen hierfür sind:
- Die Oberfläche des Leuchtstoffes streut einen großen Anteil der Primärstrahlung, so dass dieser Anteil nicht vom Leuchtstoff absorbiert werden kann,
- Die Inhomogene Verteilung der Ionen, insbesondere der Aktivatorionen, in den Leuchtstoffpartikeln führt zu einer Verringerung der inneren Quantenausbeute,
- Die kleine Einkristallitgröße von < 300 nm führt dazu, dass Oberflächeneffekte eine dominierende Rolle spielen: Zum einen bewirken die an der Oberfläche vorhandenen Störstellen im Kristallgitter eine strahlungslose Rekombination, zum anderen befinden sich Oberflächennahe Aktivatorionen unter einem nicht homogenen Kristallfeld des Gitters und stehen für Konversionseffekte nicht zur Verfügung oder behindern diese durch Energiemigration an die Oberfläche, welche wiederum mit nicht strahlender Rekombination verbunden sind.
- Im Leuchtstoff erzeugtes Fluoreszenzlicht kann zu einem gewissen Anteil den Leuchtstoff nicht verlassen, weil dieses an der Grenzfläche zur optisch dünneren Umgebung totalreflektiert wird und im Leuchtstoff über Wellenleitungsprozesse migriert und schließlich durch Reabsorption verloren geht.
- Ein großer Anteil der in den Leuchtstoff eintretenden Primärstrahlung kann nicht absorbiert werden, weil der Leuchtstoff wegen dessen langen Lebensdauer (Abklingzeit τ_{1/e} YAG:Ce = 63-67 ns, abhängig von der Ce³⁺-Konzentration, siehe Weber M.J., Solid State commun. (1973) 12, 741) der angeregten Zustände gesättigt ist.

Aus EP-0142 931 ist eine visuelle Anzeigevorrichtung bekannt, in der ein Leuchtstoff mit Granatstruktur eingesetzt wird und das Substratmaterial im wesentlichen die Zusammensetzung Y₃Al₅O₁₂ hat.

Aus EP-1095 998 ist ein Leuchtstoff der Zusammensetzung A₃B₅O₁₂: (Ce, Pr) bekannt, wobei A ein Seltenerdmetall aus der Gruppe Y, Tb, La und/oder Lu ist und B für Al und/oder Ga steht.

WO 2005/061659 beschreibt einen Leuchtstoff mit Granatstruktur des Typs A₃B₅O₁₂(Ce, Pr, Eu) mit A = Seltenerdmetall und B = Al, Ga, wobei ein Teil der Komponente B durch Si ersetzt ist.

DE 10202741 beschreibt eine rosafarbenes Licht emittierende Vorrichtung enthaltend einen Yttriumaluminium-Granat mit der Formel (Y_{3-x-y}CeₓZ_{y})Al₅O₂ oder (Y₃CeₓZ_{y})Al₅O₁₂ mit 0<x≤0.8, 0.5<y≤2.5 und Z ausgewählt aus den Seltenerdelementen, ausgenommen Cer.

WO 2006/006099 beschreibt ein Beleuchtungssystem enthaltend einen Euaktivierten Oxonitridoaluminiumsilikat-Leuchtstoff sowie gegebenenfalls weitere Konversionsleuchtstoffe z.B. der Formel (Y_{1-x-y-z}GdₓLu_{z})Al₅O₁₂:Ce_{y} (0≤x≤1, 0<y≤0.2, 0≤z≤1), wobei das Licht emittierende Element mit einer Wellenlänge im Bereich von 200 bis 430 nm emittiert.

Als Leuchtstoff werden derzeit für die weiße pcLED, die einen blau emittierenden Chip als Primärstrahlung enthalten, hauptsächlich YAG:Ce³⁺ oder Abwandlungen davon, oder auch ortho-Silikate (Ca,Sr,Ba)₂SiO₄, die mit Eu²⁺ dotiert sind, verwendet. Die Leuchtstoffe werden durch Festkörper-Diffusionsverfahren (auch "mixing and firing" genannt) hergestellt, indem oxidische

Edukte als Pulver gemischt, zermahlen und danach in einem Ofen bei Temperaturen bis zu 1700°C über bis zu mehreren Tagen in einer ggf. reduzierenden Atmosphäre geglüht werden. Als Resultat entstehen Leuchtstoffpulver, die Inhomogenitäten aufweisen in Bezug auf die Morphologie, die Partikelgrößenverteilung und die Verteilung der lumineszenten Aktivatorionen in dem Volumen der Matrix. Des weiteren sind die Morphologie, die Partikelgrößenverteilungen und weitere Eigenschaften dieser nach dem traditionellen Verfahren hergestellten Leuchtstoffe nur schlecht einstellbar und schwer reproduzierbar. Daher besitzen diese Partikel mehrere Nachteile, wie insbesondere eine inhomogene Beschichtung der LED Chips mit diesen Leuchtstoffen mit nicht optimaler und inhomogener Morphologie sowie Partikelgrößenverteilung, die zu hohen Verlustprozessen durch Streuung führen. Weitere Verluste entstehen in der Produktion dieser LEDs dadurch, dass die Leuchtstoffbeschichtung der LED Chips nicht nur inhomogen, sondern auch von LED zu LED nicht reproduzierbar ist. Dies führt dazu, dass es zu Variationen der Farbpunkte des emittierten Lichtes der pcLEDs auch innerhalb einer Charge kommt. Dadurch ist ein aufwendiger Sortierprozess der LEDs (sog. Binning) erforderlich.

Aufgabe der vorliegenden Erfindung ist es daher Konversionsleuchtstoffe für weiße LEDs oder für Color-on-demand-Anwendungen, zur Verfügung zu stellen, die eines oder mehrere der oben genannten Nachteile nicht aufweisen und warm weißes Licht erzeugen.

Überraschenderweise kann die vorliegende Aufgabe dadurch gelöst werden, dass die vorher genannten Nachteile umgangen werden, indem ein Konversionsleuchtstoff aus Th³⁺, Sb³⁺ und/oder Bi³⁺-codotierten Granaten besteht, der mit Cer aktiviert ist, wobei die bevorzugten Dotanten mindestens in einer Konzentration von 100 ppm vorliegen.

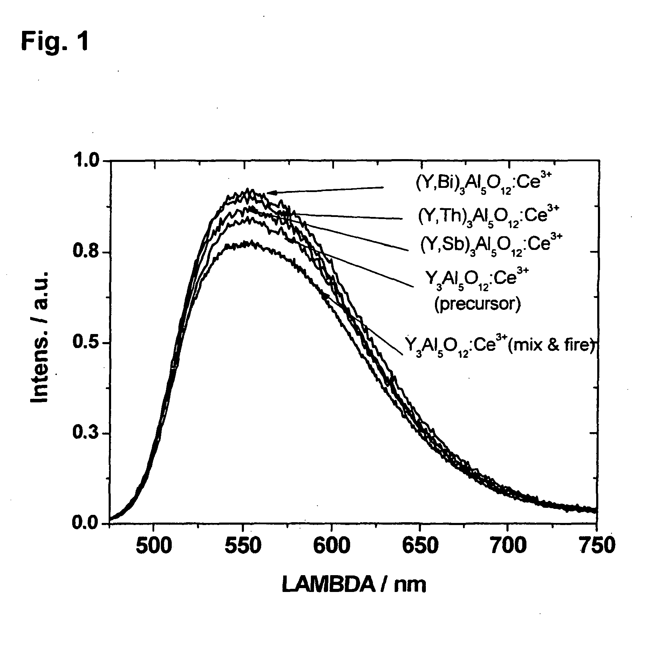

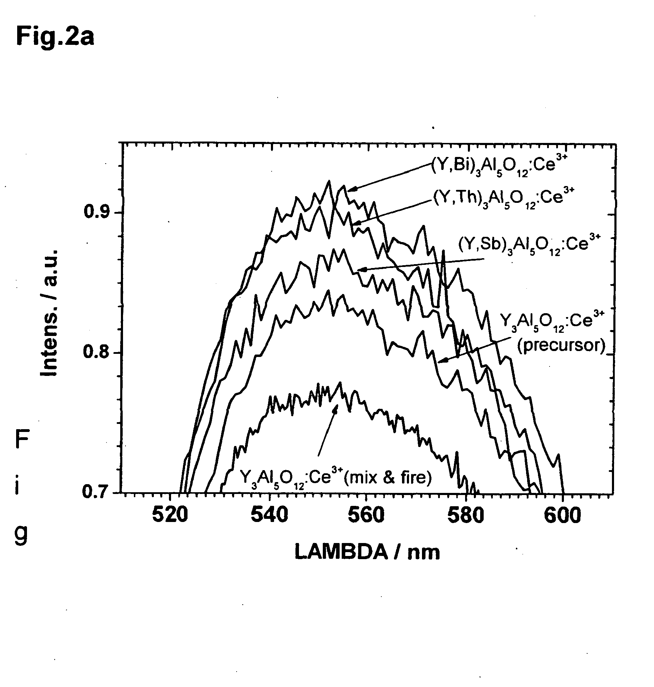

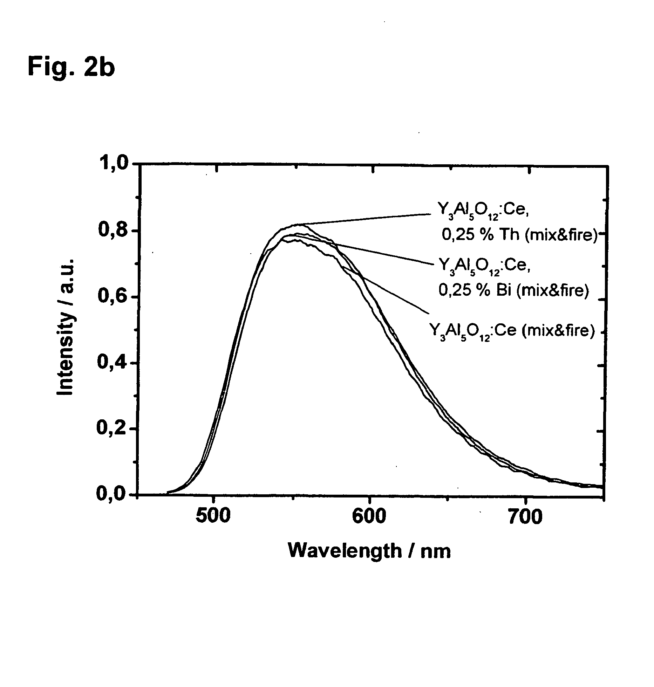

Ein weiterer überraschender Effekt besteht darin, dass die erfindungsgemäßen Leuchtstoffe eine höhere Leuchtintensität gegenüber den nicht co-dotierten und über Festkörperdiffusions-Methoden hergestellten YAG:Ce-Leuchtstoffen besitzen (vgl. Figuren 1 und 2).

Gegenstand der vorliegenden Erfindung sind somit Leuchtstoffe mit Granatstruktur der Formel II bis IV

(Y_{1-x-y}CeₓSb_{y})₃Al₅O₁₂ mit 0,005≤x≤ 0,1 und 0,001 ≤ y ≤ 0,005 (II)

(Y_{1-x-y}CeₓBi_{y})₃Al₅O₁₂ mit 0,005 s x ≤ 0,1 und 0,001 ≤ y ≤ 0,005 (III)

(Y_{1-x-y}CeₓTh_{y})₃Al₅O₁₂ mit 0,005 ≤ x s 0,1 und 0,001 ≤ y ≤ 0,005 (IV)

Unter Granatstruktur ist hier selbstverständlich auch eine geringfügig vom Idealfall des Granats abweichende, auf Fehlstellen oder Gitterstörungen beruhende Struktur gemeint, solange dieser Kristall die typische Granatstruktur beibehält. Unter der typischen Granatstruktur versteht man allgemein A₃B₅O₁₂:D, wobei A = Seltenerdmetall (SE); B = Al, Ga; und D = Aktivator, der SE ersetzt wie z.B. Cer, bedeutet.

Bevorzugt ist es, wenn die Dotierkonzentration des Cers zwischen 0.5 und 10 wt % liegt. Besonders bevorzugt liegt sie zwischen 2.0 und 5.0 wt % und am bevorzugtesten zwischen 3.0 und 3.5 wt %. Bei einer Cer-Konzentration zwischen 3.0 und 3.5% kommt es zu generell zu einer verstärkten Absorption und dadurch zu einer erhöhten Lichtausbeute bzw. einer größeren Helligkeit des Leuchtstoffes. Eine höhere Cer-Konzentration würde die Quantenausbeute reduzieren und damit wiederum zu einer verringerten Lichtausbeute führen.

Das Absorptions- und Emissionsspektrum, das thermische Löschverhalten und die Abklingzeit τ_{1/e} lumineszierender Materialien gemäß der Formel I hängen stark von der exakten Zusammensetzung der trivalenten Kationen ab. Ausschlaggebend für die oben genannten spektroskopischen Eigenschaften ist die Kristallfeldstärke der Dodekaederposition auf der Ce³⁺ eingebaut bzw. der kovalente Charakter der Ce-O-Bindungen, d.h. die effektive negative Ladung der Sauerstoffanionen und der Überlappung der Anionen- und Metallorbitale.

Allgemein lässt sich feststellen, dass mit steigender Kristallfeldstärke bzw. mit steigendem kovalenten Charakter die Ce³⁺ -Emissionsbande ([Xe]5d¹ → [Xe]4f¹ Übergang) in den roten Spektralbereich verschoben wird. Darum führen Zusammensetzungen gemäß obiger Formel I bzw. Dotierungen mit elektronenreichen ("leicht oxidierbaren") trivalenten Kationen zu einer Beeinflussung der spektralen Eigenschaften in diese Richtung.

Durch einen steigenden Anteil von einem oder mehreren der Bestandteile Bi, Sb oder Th in der Granatstruktur wird die Emissionswellenlänge des erfindungsgemäßen Leuchtstoffes nach rot verschoben. Dies ist besonders wichtig zur Erzielung von warm weißem Licht. Zur Erzeugung von konfortablem Licht mit einer hohen Farbwiedergabe ist es vorteilhaft, wenn eine Mischung aus verschiedenen Leuchtstoffen eingesetzt wird, nämlich ein grünverschobener Leuchtstoff, wie beispielsweise Y₃(Al,Ga)₅O₁₂ und dem erfindungsgemäßen Leuchtstoff, sowie eines roten Leuchtstoffes (z.B. ein roter Banden- oder Linienemitter, welcher ein hohes Lumenäquivalent beisteuern kann, wie Europium-dotierte Wolframate, Molybdate und/oder Phosphate). Ferner können auch blaugrüne Leuchtstoffe hinzugemischt werden wie z.B. Lu₃Al₅O₁₂:Ce (LUAG:Ce). Dadurch ergibt sich ein annähernd kontinuierliches Emissionsspektrum, welches stark dem VIS-Tageslichtspektrum der Sonne ähnelt.

Die Partikelgröße der erfindungsgemäßen Leuchtstoffe beträgt zwischen 50 nm und 30 µm, vorzugsweise zwischen 1 µm und 20 µm.

In einer weiteren Ausführungsform kann der Leuchtstoff der Formel II bis IV zusätzlich mindestens einem weiteren der folgenden Leuchtstoffmaterialien enthalten:
Oxide, Molybdate, Wolframate, Vanadate, Gruppe-III Nitride, (Oxi)-nitride jeweils einzeln oder Gemischen derselben mit einem oder mehreren Aktivatorionen wie Ce, Eu, Mn, Cr und/oder Bi.

Dies ist besonders dann von Vorteil, wenn bestimmte Farbräume eingestellt werden sollen.

In einer weiteren bevorzugten Ausführungsform besitzt der Leuchtstoff auf der, einem LED Chip entgegengesetzten Seite eine strukturierte (z.B. pyramidale) Oberfläche (siehe DE 102006054330.0, Merck, die voll umfänglich in den Kontext der vorliegenden Anmeldung durch Bezugnahme eingefügt wird). Somit kann möglichst viel Licht aus dem Leuchtstoff ausgekoppelt werden.

Die strukturierte Oberfläche auf dem Leuchtstoff wird durch nachträgliches Beschichten mit einem geeigneten Material, welches bereits strukturiert ist, oder in einem nachfolgenden Schritt durch (photo-) lithografische Verfahren, Ätzverfahren oder durch Schreibverfahren mit Energie- oder Materiestrahlen oder Einwirkung von mechanischen Kräften hergestellt.

In einer weiteren bevorzugten Ausführungsform besitzen die erfindungsgemäßen Leuchtstoffe auf der, einem LED Chip entgegengesetzten Seite eine raue Oberfläche, die Nanopartikel aus SiO₂, TiO₂, Al₂O₃, ZnO₂, ZrO₂ und/oder Y₂O₃ oder Kombinationen aus diesen Materialien oder aus Partikeln mit der Leuchtstoffzusammensetzung trägt. Dabei hat eine raue Oberfläche eine Rauhigkeit von bis zu einigen 100 nm. Die beschichtete Oberfläche hat den Vorteil, dass Totalreflexion verringert oder verhindert werden kann und das Licht besser aus dem erfindungsgemäßen Leuchtstoff ausgekoppelt werden kann (siehe DE 102006054330.0 (Merck), die voll umfänglich in den Kontext der vorliegenden Anmeldung durch Bezugnahme eingefügt wird.)

Weiterhin bevorzugt ist es, wenn die erfindungsgemäßen Leuchtstoffe auf der dem Chip abgewandten Oberfläche eine Brechzahl angepasste Schicht besitzen, welche die Auskopplung der Primärstrahlung und oder der vom Leuchtstoffkörper emittierten Strahlung erleichtert.

In einer weiteren bevorzugten Ausführungsform besitzen die Leuchtstoffe eine geschlossene Oberflächenbeschichtung, die aus SiO₂, TiO₂, Al₂O₃, ZnO, ZrO₂ und/oder Y₂O₃ oder Mischoxide daraus besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächebeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn die Leuchtstoffe eine poröse Oberflächenbeschichtung besitzen, die aus SiO₂, TiO₂, Al₂O₃, ZnO, ZrO₂ und/oder Y₂O₃ oder Mischoxide daraus oder aus der Leuchtstoffzusammensetzung besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzen die Leuchtstoffe eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf dem LED Chip aufgebrachte erfindungsgemäße Leuchtstoffschicht vorzugsweise aus einem Gemisch von Silikon und homogenen Leuchtstoffpartikeln besteht, und das Silikon eine Oberflächenspannung aufweist, ist diese Leuchtstoffschicht auf mikroskopischer Ebene nicht einheitlich bzw. ist die Dicke der Schicht nicht durchweg konstant.

Ein weiterer Gegenstand der vorliegenden Erfindung ist ein Leuchtstoff mit Granatstruktur erhältlich durch Mischen von Aluminium-, Yttrium- und Cer-haltigen Edukten mit mindestens einem Antimon, Bismut, und/oder Thorium-haltigen Co-Dotierstoff nach nasschemischen Methoden und anschließender thermischer Nachbehandlung.

Die Edukte zur Herstellung des Leuchtstoffs bestehen, wie oben erwähnt, aus dem Basismaterial (z. B. Salzlösungen des Aluminiums, Yttriums und Cer) sowie mindestens mindestens einem Sb, Bi, oder Th-haltigen Dotierstoff. Als Edukte kommen anorganische und/oder organische Stoffe wie Nitrate, Carbonate, Hydrogencarbonate, Phosphate, Carboxylate, Alkoholate, Acetate, Oxalate, Halogenide, Sulfate, metallorganische Verbindungen, Hydroxide und/oder Oxide der Metalle, Halbmetalle, Übergangsmetalle und/oder Seltenerden in Frage, welche in anorganischen und/oder organischen Flüssigkeiten gelöst und/oder suspendiert sind. Vorzugsweise werden Mischnitratlösungen, Chlorid- oder Hydroxidlösungen eingesetzt, welche die entsprechenden Elemente im erforderlichen stöchiometrischen Verhältnis enthalten.

Ein weiterer Gegenstand der vorliegenden Erfindung ist ein Verfahren zur Herstellung eines Leuchtstoff mit folgenden Verfahrensschritten:
a) Herstellen einer Cer-aktivierten Leuchtstoffes, der mit Sb-, Bi- und/oder Th-haltigen Materialien codotiert wird, aus Leuchtstoffprecursor-Suspensionen oder Lösungen durch Mischen von mindestens drei Edukten ausgewählt aus Y-, Al- und Ce-, haltigen Materialien nach nasschemischen Methoden.
b) Thermische Nachbehandlung des Sb-, Bi- und/oder Th-codotierten Leuchtstoffes.

Die nasschemische Herstellung besitzt gegenüber der herkömmlichen Festkörperdiffusions-Methode generell den Vorteil, dass die resultierenden Materialien eine höhere Einheitlichkeit in Bezug auf die stöchiometrische Zusammensetzung, die Partikelgröße und die Morphologie der Partikel aufweisen, aus denen der erfindungsgemäße Leuchtstoff hergestellt wird.

Für die nasschemische Vorbehandlung einer wässrigen Vorstufe der Leuchtstoffe (Leuchtstoffprecursoren) bestehend z.B. aus einem Gemisch von Yttriumnitrat-, Aluminiumnitrat-, Cernitrat- und Bismutnitratlösung sind folgende bekannte Methoden bevorzugt:
- Cofällung mit einer NH₄HCO₃-Lösung (*siehe z.B.* Jander, Blasius Lehrbuch der analyt. u. präp. anorg. Chem. 2002*)*
- Pecchini-Verfahren mit einer Lösung aus Zitronensäure und Ethylenglykol (*siehe z.B.* Annual Review of Materials Research Vol. 36: 2006, 281-331*)*
- Combustion-Verfahren unter Verwendung von Harnstoff
- Sprühtrocknung wässriger oder organischer Salzlösungen (Edukte)
- Sprühpyrolyse (auch Spraypyrolyse genannt) wässriger oder organischer Salzlösungen (Edukte)
- Eindampfen von Nitratlösungen und thermischer Umsetzung des Rückstandes

Bei der o.g. Cofällung werden z.B. Nitratlösungen der entsprechenden Leuchtstoffedukte mit einer NH₄HCO₃-Lösung versetzt, wodurch sich der Leuchtstoffprecursor bildet.

Beim Pecchini-Verfahren werden z.B. die o.g. Nitratlösungen der entsprechenden Leuchtstoffedukte bei Raumtemperatur mit einem Fällungsreagenz bestehend aus Zitronensäure und Ethylenglykol versetzt und anschließend erhitzt. Durch Erhöhung der Viskosität kommt es zur Leuchtstoffprecursor-Bildung.

Beim bekannten Combustion-Verfahren werden z.B. die o.g. Nitratlösungen der entsprechenden Leuchtstoffedukte in Wasser gelöst, dann unter Rückfluss gekocht und mit Harnstoff versetzt, wodurch sich der Leuchtstoffprecursor langsam bildet.

Die Sprühpyrolyse gehört zu den Aerosolverfahren, die durch Versprühen von Lösungen, Suspensionen oder Dispersionen in einen durch unterschiedliche Art und Weise erhitzten Reaktionsraum (Reaktor) sowie die Bildung und Abscheidung von Feststoff- Partikeln gekennzeichnet sind. Im Gegensatz zur Sprühtrocknung mit Heißgastemperaturen < 200°C finden bei der Sprühpyrolyse als Hochtemperatur- Prozess außer der Verdampfung des Lösungsmittels zusätzlich die thermische Zersetzung der verwendeten Edukte (z. B. Salze) sowie die Neubildung von Stoffen (z. B. Oxide, Mischoxide) statt.

Die oben genannten 6 Verfahrensvarianten sind ausführlich in der DE 102006027133.5 (Merck) beschrieben, die voll umfänglich in den Kontext der vorliegenden Anmeldung durch Bezugnahme eingefügt wird.

Die Herstellung der erfindungsgemäßen Leuchtstoffe kann nach verschiedenen nasschemischen Methoden erfolgen, indem
1) eine homogene Ausfällung der Bestandteile erfolgt, gefolgt von der Abtrennung des Lösemittels und einer ein- oder mehrstufigen thermischen Nachbehandlung, wobei ein Schritt davon in reduzierender Atmosphäre erfolgen kann,
2) die Mischung fein verteilt wird, beispielsweise mit Hilfe eines Sprühprozesses und eine Entfernung des Lösemittels erfolgt, gefolgt von einer ein -oder mehrstufigen thermischen Nachbehandlung, wobei ein Schritt davon in reduzierender Atmosphäre erfolgen kann, oder
3) die Mischung fein verteilt wird, beispielsweise mit Hilfe eines Sprühprozesses und eine Entfernung des Lösemittels einhergehend mit einer Pyrolyse erfolgt, gefolgt von einer ein- oder mehrstufigen thermischen Nachbehandlung, wobei ein Schritt davon in reduzierender Atmosphäre erfolgen kann.
4) die mit Hilfe der Methoden 1 - 3 hergestellten Leuchtstoffe nachträglich beschichtet werden, um eine Brechzahlanpassung zu ihrer Umgebung zu erzielen.

Vorzugsweise geschieht die nasschemische Herstellung des Leuchtstoffes nach dem Präzipitations- und/oder Sol-Gel-Verfahren.

Bei der oben genannten thermischen Nachbehandlung ist es bevorzugt, wenn die Glühung zumindest teilweise unter reduzierenden Bedingungen (z.B. mit Kohlenmonoxid, Formiergas, reinen oder Wasserstoff oder zumindest Vakuum oder Sauerstoffmangel-Atmosphäre) durchgeführt wird.

Generell ist es auch möglich, die erfindungsgemäßen Leuchtstoffe über die Festkörperdiffusions-Methode herzustellen, was jedoch die schon erwähnten Nachteile verursacht.

Mit Hilfe der o.g. Verfahren können beliebige äußere Formen der Leuchtstoffpartikel hergestellt werden, wie sphärische Partikel, Plättchen und strukturierte Materialien und Keramiken.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und DE 102006054331.9 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1 : 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.

Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.

Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Leuchtstoffe in Form von keramischen Körpern erfolgt analog nach dem in der DE 102006037730 (Merck) beschrieben Verfahren, die voll umfänglich in den Kontext der vorliegenden Anmeldung durch Bezugnahme eingefügt wird. Dabei wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche des Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneider der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.

Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die Anregbarkeit der erfindungsgemäßen Leuchtstoffe erstrecken sich zudem über einen weiten Bereich, der von etwa 410 nm bis 530 nm, bevorzugt 430 nm bis zu etwa 500 nm reicht. Damit sind diese Leuchtstoffe nicht nur zur Anregung durch UV oder blau emittierende Primärlichtquellen wie LEDs oder konventionelle Entladungslampen (z.B. auf Hg-Basis) geeignet, sondern auch für Lichtquellen wie solche, welche die blaue In³⁺ - Linie bei 451 nm ausnutzen.

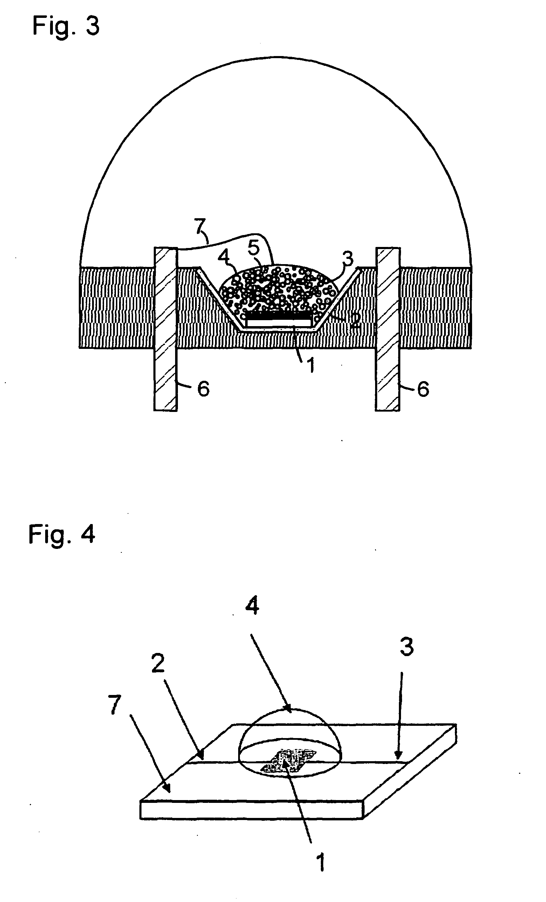

Ein weiterer Gegenstand der vorliegenden Erfindung ist eine Beleuchtungseinheit mit mindestens einer Primärlichtquelle, dessen Emissionsmaximum bzw. -maxima im Bereich 410 nm bis 530 nm, bevorzugt 430 nm bis zu etwa 500 nm reicht. Insbesondere bevorzugt ist ein Bereich zwischen 440 und 480 nm, wobei die primäre Strahlung teilweise oder vollständig durch die erfindungsgemäßen Leuchtstoffe in längerwellige Strahlung konvertiert wird. Vorzugsweise ist diese Beleuchtungseinheit weiß emittierend oder emittiert Licht mit einem bestimmten Farbpunkt (Color-on-demand-Prinzip). Bevorzugte Ausführungsformen der erfindungsgemäßen Beleuchtungseinheiten sind in den Figuren 3 bis 14 dargestellt.

In einer bevorzugten Ausführungsform der erfindungsgemäßen Beleuchtungseinheit handelt es sich bei der Lichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.

Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Beleuchtungseinheit handelt es sich bei der Lichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der erfindungsgemäßen Beleuchtungseinheit handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Die erfindungsgemäßen Leuchtstoffe können entweder in einem Harz dispergiert (z.B. Epoxy- oder Siliconharz), oder bei geeigneten Größenverhältnissen direkt auf der Primärlichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

In einer weiteren Ausführungsform ist es bevorzugt, wenn die optische Ankopplung der Beleuchtungseinheit zwischen dem Leuchtstoff und der Primärlichtquelle durch eine lichtleitende Anordnung realisiert wird. Dadurch ist es möglich, dass an einem zentralen Ort die Primärlichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Leuchtstoffe zur teilweisen oder vollständigen Konversion der blauen oder im nahen UV-liegenden Emission einer Lumineszenzdiode.

Weiterhin bevorzugt ist die Verwendung der erfindungsgemäßen Leuchtstoffe zur Konversion der blauen oder im nahen UV-liegenden Emission in sichtbare weiße Strahlung. Weiterhin ist die Verwendung der erfindungsgemäßen Leuchtstoffe zur Konversion der Primärstrahlung in einen bestimmten Farbpunkt nach dem "Color on demand"-Konzept bevorzugt.

Ein weiterer Gegenstand der vorliegenden Erfindung ist die Verwendung der erfindungsgemäßen Leuchtstoffe in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Herstellung des Leuchtstoffes (Y_{0,939}Ce_{0,06}Th_{0,001})₃Al₅O₁₂ nach nasschemischem Verfahren

537,6 g Ammoniumhydrogencarbonat werden in 3 Litern VE-Wasser gelöst. In ca. 400 ml VE-Wasser werden 205,216 g Aluminiumchlorid Hexahydrat, 151,522 g Yttriumchlorid Hexahydrat, 3,617 g Cerchlorid Hexahydrat sowie 0,191 g Thorium(IV)chlorid gelöst und zügig zur Hydrogencarbonatlösung zugetropft, dabei muss der pH-Wert durch Zugabe von konz. Ammoniak bei pH 8 gehalten werden. Anschließend wird noch eine Stunde weitergerührt. Nach dem Altern wird der Niederschlag abfiltriert und im Trockenschrank bei ca. 120°C getrocknet.

Der getrocknete Niederschlag wird gemörsert und anschließend 4 Stunden bei 1000 °C an Luft kalziniert. Anschließend wird das Produkt erneut gemörsert und 8 Stunden bei 1700 °C in in einer Wasserstoff/ArgonAtmosphäre kalziniert.

### Beispiel 2: Herstellung des Leuchtstoffes (Y_{0,939}Ce_{0,06}Bi_{0,001})₃Al₅O₁₂ nach nasschemischem Verfahren

537,6 g Ammoniumhydrogencarbonat werden in 3 Litern VE-Wasser gelöst. In ca. 400 ml VE-Wasser werden 205,216 g Aluminiumchlorid Hexahydrat, 151,522 g Yttriumchlorid Hexahydrat, 3,617 g Cerchlorid Hexahydrat sowie 0,161 g Bismut(III)chlorid gelöst und zügig zur Hydrogencarbonatlösung zugetropft, dabei muss der pH-Wert durch Zugabe von konz. Ammoniak bei pH 8 gehalten werden. Anschließend wird noch eine Stunde weitergerührt. Nach dem Altern wird der Niederschlag abfiltriert und im Trockenschrank bei ca. 120°C getrocknet.

Der getrocknete Niederschlag wird gemörsert und anschließend 4 Stunden bei 1000 °C an Luft kalziniert. Anschließend wird das Produkt erneut gemörsert und 8 Stunden bei 1700 °C in einer Wasserstoff/ArgonAtmosphäre kalziniert.

### Beispiel 3: Herstellung des Leuchtstoffes (Y_{0,939}Ce_{0,06}Sb_{0,001})₃Al₅O₁₂ nach nasschemischem Verfahren

537,6 g Ammoniumhydrogencarbonat werden in 3 Litern VE-Wasser gelöst. In ca. 400 ml VE-Wasser werden 205,216 g Aluminiumchlorid Hexahydrat, 151,522 g Yttriumchlorid Hexahydrat, 3,617 g Cerchlorid Hexahydrat sowie 0,116 g Antimon(III)chlorid gelöst und zügig zur Hydrogencarbonatlösung zugetropft, dabei muss der pH-Wert durch Zugabe von konz. Ammoniak bei pH 8 gehalten werden. Anschließend wird noch eine Stunde weitergerührt. Nach dem Altern wird der Niederschlag abfiltriert und im Trockenschrank bei ca. 120°C getrocknet.

Der getrocknete Niederschlag wird gemörsert und anschließend 4 Stunden bei 1000 °C an Luft kalziniert. Anschließend wird das Produkt erneut gemörsert und 8 Stunden bei 1700 °C in einer Wasserstoff/ArgonAtmosphäre kalziniert.

### Beispiel 4: Herstellung von YAG:Ce (mit Ce-Dotierkonzentration 2%, Y_{2,94}Al₅O₁₂:Ce_{0,06}³⁺) nach der Mixing & Firing-Methode (FestkörperDiffusion)

Es werden 0,344 g Cerdioxid (CeO₂), 33,646 g Yttriumoxid (Y₂O₃) und 25,491 g Aluminiumoxid (Al₂O₃) eingewogen und mit Wasser aufgeschlämmt. Diese Mischung wird durch Einsatz einer geringen Menge Wasser im Mörser nass gemahlen. Die Aufschlämmung wird danach in einen Kammerofen überführt und dort in Formiergasatmosphäre bei einer Temperatur von 1200°C über einen Zeitraum von 6 h kalziniert.

Nach Abkühlen wird das Material erneut fein gemahlen und im Ofen reduktiv kalziniert bei einer Temperatur von 1700°C über einen Zeitraum von 8 Stunden.

### Beispiel 5: Herstellung von YAG:Ce (mit Ce-Dotierkonzentration 2%, Y_{2,94}Al₅O₁₂:Ce_{0,06}³⁺) nach der nasschemischen Methode

537,6 g Ammoniumhydrogencarbonat werden in 3 Litern VE-Wasser gelöst. In ca. 400 ml VE-Wasser werden 205,216 g Aluminiumchlorid Hexahydrat, 153,242 g Yttriumchlorid Hexahydrat und 3,617 g Cerchlorid Hexahydrat gelöst und zügig zur Hydrogencarbonatlösung zugetropft, dabei muss der pH-Wert durch Zugabe von konz. Ammoniak bei pH 8 gehalten werden. Anschließend wird noch eine Stunde weitergerührt. Nach dem Altern wird der Niederschlag abfiltriert und im Trockenschrank bei ca. 120°C getrocknet.

Der getrocknete Niederschlag wird gemörsert und anschließend 4 Stunden bei 1000 °C an Luft kalziniert. Anschließend wird das Produkt erneut gemörsert und 8 Stunden bei 1700 °C in einer WasserstofflArgon-Atmosphäre kalziniert.

### Beispiele 6 bis 8:Herstellung der Leuchtstoffe (Y_{0,98-x}Ce_{0,02}Thₓ)₃Al₅O₁₂ mit x = 0,001; x = 0.0025 und x = 0.005 nach der Mixing & firing-Methode (Festkörperdiffusion)

12,5 mmol gamma-Aluminiumoxid Al₂O₃, 7,35 mmol - x Yttriumoxid Y₂O₃, 0,3 mmol Cerdioxid CeO₂ und 0,015 mmol ≤ x ≤ 0,075 mmol Thoriumoxid ThO₂ eingewogen. Anschließend werden die Edukte mit Aceton aufgeschlämmt und gründlich gemörsert. Im ersten Kalzinierschritt werden die Proben für zwei Stunden unter Kohlenmonoxid bei 1200 °C geheizt. Nach erneutem gründlichen Mörsern folgt der zweite Kalzinierschritt, bei dem der Ansatz für vier Stunden bei 1650 °C ebenfalls unter Kohlenmonoxid-Atmosphäre geheizt wird.

Nach dem abschließenden Mörsern erfolgt die Charakterisierung der Proben durch Röntgenpulverdiffraktometrie, Lumineszenz- und Reflexionsspektroskopie.

### Beschreibung der Abbildungen

Im folgenden soll die Erfindung anhand mehrerer Ausführungsbeispiele näher erläutert werden. Es zeigen:
Fig. 1: Emissionsspektren der erfindungsgemäßen Leuchtstoffe (Y,Bi)₃Al₅O₁₂:Ce, (Y,Th)₃Al₅O₁₂:Ce und (Y,Sb)₃Al₅O₁₂:Ce im Vergleich zu einem kommerziell erhältlichen 2% Ce enthaltendem reinem Y₃Al₅O₁₂:Ce, welches über Festkörper-Diffusionsreaktion (mix & fire) hergestellt wird und einem reinen YAG:Ce (precursor), welches nasschemisch hergestellt wird. Die Anregungswellenlänge beträgt 450 nm (x-Achse: LAMBDA/ nm= Wellenlänge in nm; y-Achse: Intens./nm = Fluoreszenzintensität in willkürlichen Einheiten).
Fig. 2a: vergrößerte Darstellung der Emissionsspektren zur besseren Verdeutlichung der unterschiedlichen Emissionsmaxima. Die nasschemisch hergestellten und mit Bi, Th bzw. Sb dotierten erfindungsgemäßen Leuchtstoffe weisen überraschenderweise eine höhere Fluoreszenz-Intensität auf als das kommerzielle über Festkörper-Diffusionsreaktionen hergestellte reine YAG:Ce und das nasschemisch hergestellte reine YAG:Ce.
   Farbpunkte im (x,y) CIE 1937 Chromaticity-Diagram:

   (Y_{0,969}Ce_{0,02}X_{0,001})₃Al₅O₁₂

   Mit X = Sb: (x / y) = 0,438 / 0,541,
   mit X = Bi: (x / y) = 0,440 / 0,539,
   mit X = Th: (x / y) = 0,439 / 0,541
   Kommerzielles YAG:Ce, über Festkörper-Diffusionsreaktion hergestellt: (x / y) = 0,435 / 0,541
   YAG:Ce nass-chemisch hergestellt:
   (x/y) = 0.435/ 0.541
Fig. 2b: Emissionsspektren der erfindungsgemäßen Leuchtstoffe (Y,Bi)₃Al₅O₁₂:Ce und (Y,Th)₃Al₅O₁₂:Ce, die über Festkörper-Diffusionsreaktion (mix & fire) im Vergleich zum nicht codotierten YAG:Ce hergestellt wurden.
Fig. 3: zeigt die schematische Abbildung einer Leuchtdiode mit einer Leuchtstoff-haltigen Beschichtung. Das Bauteil umfasst eine Chip-artige Leuchtdiode (LED) 1 als Strahlungsquelle. Die Licht emittierende Diode ist in einem becherförmigen Reflektor angebracht, der von einem Justagerahmen 2 gehalten wird. Der Chip 1 ist über ein Flachkabel 7 mit einem ersten Kontakt 6 und direkt mit einem zweiten elektrischen Kontakt 6' verbunden. Auf die innere Wölbung des Reflektorbechers wurde eine Beschichtung aufgebracht, die einen erfindungsgemäßen Konversionsleuchtstoff enthält. Die Leuchtstoffe werden entweder getrennt voneinander oder als Mischung eingesetzt. (Liste der Teilenummern: 1 Leuchtdiode, 2 Reflektor, 3 Harz, 4 Konversionsleuchtstoff, 5 Diffusor, 6 Elektroden, 7 Flachkabel)
Fig. 4: zeigt ein COB (Chip on board) Package des Typs InGaN, das als Lichtquelle (LED) für weißes Licht dient (1=Halbleiterchip; 2,3 = elektr. Anschlüsse; 4 = Konversionsleuchtstoff; 7 = Board (Platine) Der Leuchtstoff ist in einer Bindemittellinse verteilt, die gleichzeitig ein sekundäres optisches Element darstellt und die Lichtabstrahlcharakteristik als Linse beeinflusst.

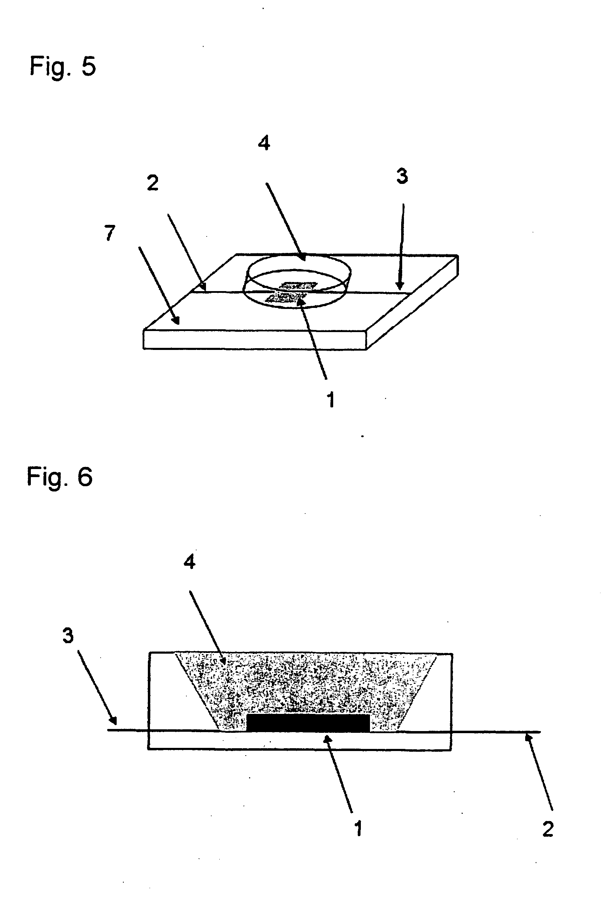

Fig. 5: zeigt ein COB (Chip on board) Package des Typs InGaN, das als Lichtquelle (LED) für weißes Licht dient (1=Halbleiterchip; 2,3 = elektr. Anschlüsse; 4 = Konversionsleuchtstoff; 7 = Board (Platine) Der Leuchtstoff befindet sich in einer dünnen Bindemittelschicht verteilt direkt auf dem LED Chip. Ein sekundäres optisches Element bestehend aus einem transparenten Material kann darauf platziert werden.
Fig. 6: zeigt ein Golden Dragon^{®} Package, das als Lichtquelle (LED) für weißes Licht dient (1=Halbleiterchip; 2,3 = elektr. Anschlüsse; 4 = Konversionsleuchtstoff in Kavität mit Reflektor). Der Konversionsleuchtstoff befindet sich in einem Bindemittel dispergiert, wobei die Mischung die Kavität ausfüllt.

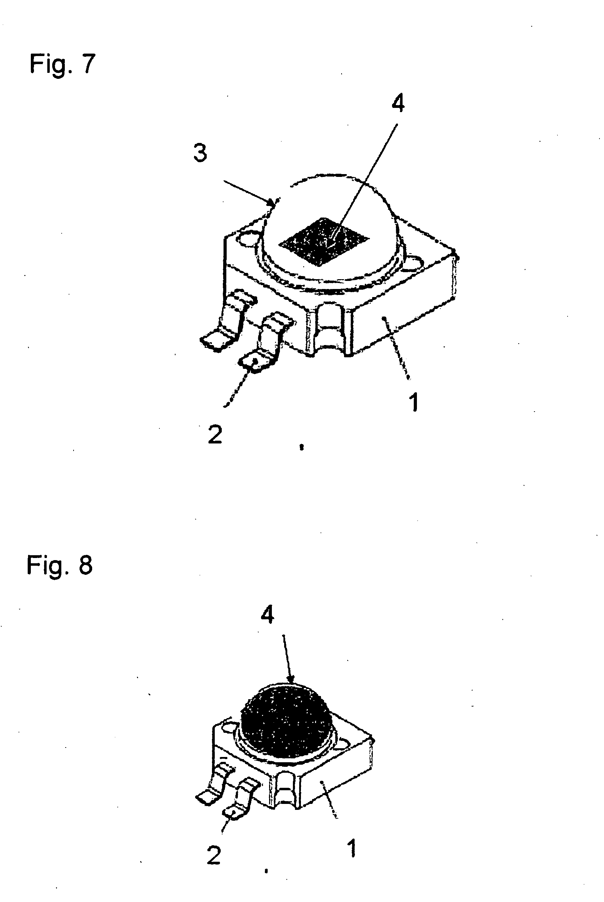

Fig. 7: zeigt ein Luxeon^{®} Package, wobei 1= Gehäuse; 2 = elektr. Anschluss; 3 = Linse; 4= Halbleiterchip bedeutet. Dieses Design hat den Vorteil, dass es sich um ein Flipchip-Design handelt, wobei über das transparente Substrat und einem Reflektor auf dem Boden ein größerer Anteil des Lichtes aus dem Chip für Lichtzwecke verwendet werden kann. Außerdem ist die Wärmeableitung bei diesem Design begünstigt.
Fig. 8: zeigt ein Package , wobei 1= Gehäuse; 2 = elektr. Anschluss; 4= Halbleiterchip bedeutet, und der Hohlraum unterhalb der Linse komplett mit dem erfindungsgemäßen Konversionsleuchtstoff ausgefüllt ist. Dieses Package hat den Vorteil, dass eine größere Menge Konversionsleuchtstoff verwendet werden kann. Dieser kann auch als Remote Phosphor wirken.

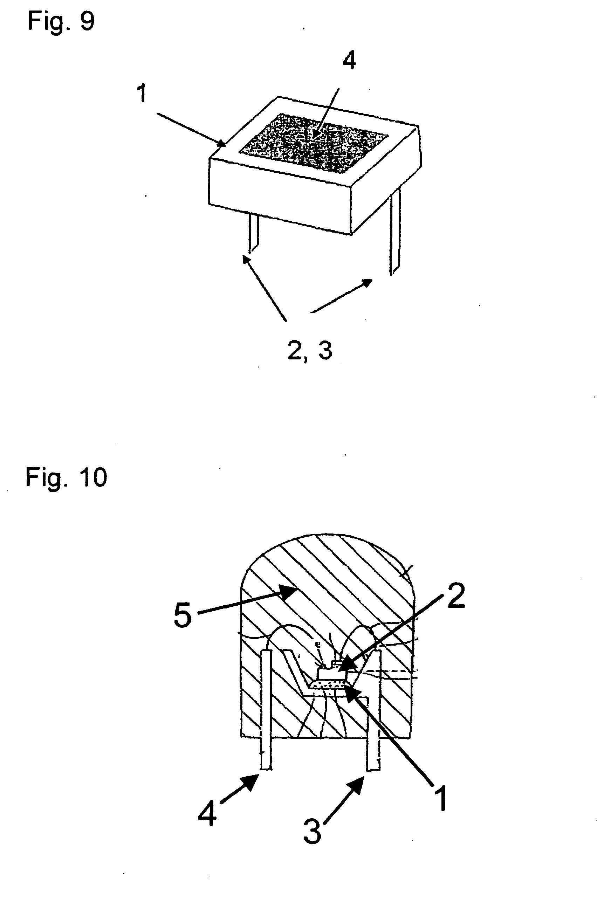

Fig. 9: zeigt ein SMD-Package (Surface mounted package) wobei 1= Gehäuse; 2, 3 = elektr. Anschlüsse, 4 = Konversionsschicht bedeutet. Der Halbleiterchip ist komplett mit dem erfindungsgemäßen Leuchtstoff bedeckt. Das SMD-Design hat den Vorteil, dass es eine kleine Bauform hat und somit in herkömmliche Leuchten passt.
Fig. 10: zeigt ein T5-Package, wobei 1= Konversionsleuchtstoff; 2 = Chip; 3,4 = elektr. Anschlüsse; 5 = Linse mit transparenten Harz bedeutet. Der Konversionsleuchtstoff befindet sich auf der Rückseite des LED-Chips, was den Vorteil hat, dass der Leuchtstoff über die metallischen Anschlüsse gekühlt wird.

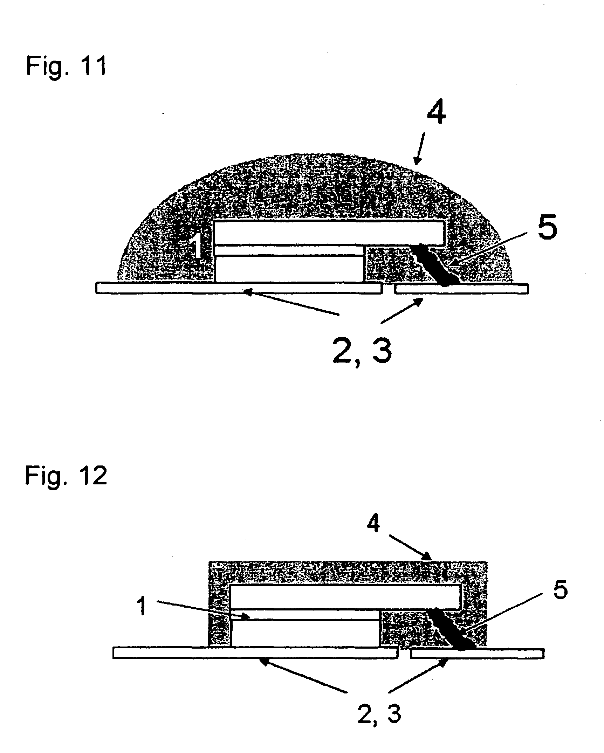

Fig. 11: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff in einem Bindemittel als Top Globe aufgebracht ist. Diese Form der Leuchtstoff-/Bindemittelschicht kann als sekundäres optisches Element wirken und z. B. die Lichtausbreitung beeinflussen.
Fig. 12: zeigt eine schematische Abbildung einer Leuchtdiode mit 1= Halbleiterchip; 2,3 = elektr. Anschlüsse; 4 =Konversionsleuchtstoff, 5 = Bonddraht, wobei der Leuchtstoff als dünne Schicht in einem Bindemittel dispergiert aufgebracht ist. Auf diese Schicht lässt sich leicht ein weiteres, als sekundäres optisches Element wirkendes Bauteil, wie z.B eine Linse aufbringen.

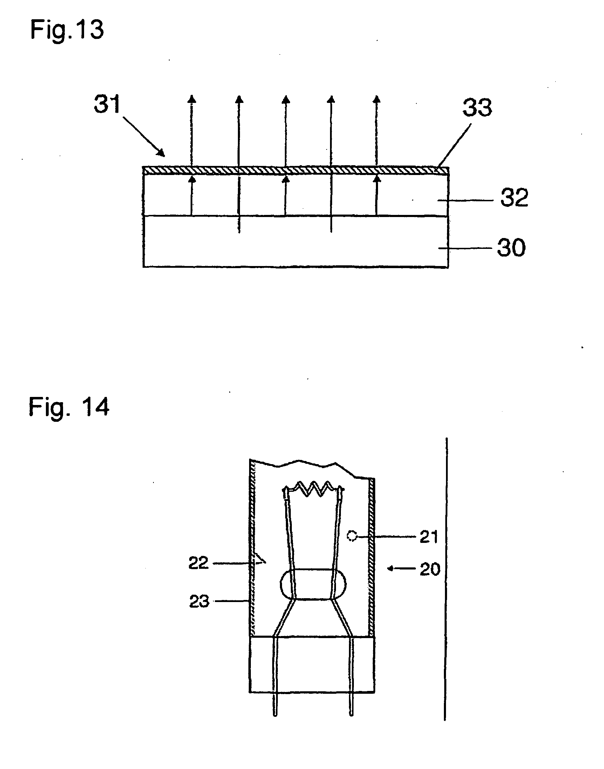

Fig. 13: zeigt ein Beispiel für eine weitere Anwendung, wie sie im Prinzip bereits aus US-B 6,700,322 bekannt ist. Dabei wird der erfindungsgemäße Leuchtstoff zusammen mit einer OLED angewendet. Die Lichtquelle ist eine organisch lichtemittierende Diode 31, bestehend aus der eigentlichen organischen Folie 30 und einem transparenten Substrat 32. Die Folie 30 emittiert insbesondere blaues primäres Licht, erzeugt beispielsweise mittels PVK:PBD:Kumarin (**PVK**, Abk. für Poly(n-vinylcarbazol); **PBD**, Abk. für 2-(4-biphenyl)-5-(4-tert.-butylphenyl)-1,3,4-oxadiazol)). Die Emission wird von einer Deckschicht, gebildet aus einer Schicht 33 des erfindungsgemäßen Leuchtstoffs, teilweise in gelbes, sekundär emittiertes Licht umgewandelt, so dass insgesamt durch Farbmischung des primär und sekundär emittierten Lichts eine weiße Emission realisiert wird. Die OLED besteht im wesentlichen aus mindestens einer Schicht eines lichtemittierenden Polymers oder von sog. small molecules zwischen zwei Elektroden, die aus an sich bekannten Materialien bestehen, wie beispielsweise ITO (Abk. für "indium tin oxide") als Anode und ein hochreaktives Metall, wie z.B. Ba oder Ca, als Kathode. Oft werden auch mehrere Schichten zwischen den Elektroden verwendet, die entweder als Lochtransportschicht dienen oder im Bereich der "small molecules" auch als Elektronentransportschichten dienen. Als emittierende Polymere kommen beispielsweise Polyfluorene oder Polyspiro-Materialien zum Einsatz.
Fig. 14: zeigt eine Niederdrucklampe 20 mit einer quecksilberfreien Gasfüllung 21 (schematisiert), die eine Indium-Füllung und ein Puffergas analog WO 2005/061659 enthält, wobei eine Schicht 22 aus den erfindungsgemäßen Leuchtstoffen angebracht ist.

## Patentansprüche

1. Leuchtstoff mit Granatstruktur, **dadurch gekennzeichnet, dass** es sich um eine Verbindung ausgewählt aus den Verbindungen mit den Formeln II bis IV handelt:
(Y_{1-x-y}CeₓSb_{y})₃Al₅O₁₂ mit 0,005 ≤ x ≤ 0,1 und 0,001 ≤ y ≤ 0,005 (II)
(Y_{1-x-y}CeₓBi_{y})₃Al₅O₁₂ mit 0,005 ≤ x ≤ 0,1 und 0,001 ≤ y ≤ 0,005 (III)
(Y_{1-x-y}CeₓTh_{y})₃Al₅O₁₂ mit 0,005 ≤ x ≤ 0,1 und 0,001 ≤ y ≤ 0,005 (IV)

2. Leuchtstoff nach Anspruch 1, **dadurch gekennzeichnet, dass** er eine Oberfläche besitzt, die Nanopartikel aus SiO₂, TiO₂, Al₂O₃, ZnO, ZrO₂ und/oder Y₂O₃ oder Mischoxide daraus oder Partikel mit der Leuchtstoffzusammensetzung trägt.

3. Leuchtstoff nach Anspruch 1 oder 2, **dadurch gekennzeichnet, dass** er eine geschlossene Oberflächenbeschichtung besitzt, die aus SiO₂, TiO₂, Al₂O₃, ZnO, ZrO₂ und/oder Y₂O₃ oder Mischoxiden daraus besteht.

4. Leuchtstoff nach einem oder mehreren der Ansprüche 1 bis 3, **dadurch gekennzeichnet, dass** er eine poröse Oberflächenbeschichtung besitzt, die aus SiO₂, TiO₂, Al₂O₃, ZnO, ZrO₂ und/oder Y₂O₃ oder Mischoxide daraus oder aus der Leuchtstoffzusammensetzung besteht.

5. Leuchtstoff nach einem oder mehreren der Ansprüche 1 bis 4, **dadurch gekennzeichnet, dass** die Oberfläche funktionelle Gruppen trägt, welche eine chemische Anbindung an die Umgebung, vorzugsweise bestehend aus Epoxy- oder Silikonharz, ermöglicht.

6. Leuchtstoff nach einem oder mehreren der Ansprüche 1 bis 5, erhältlich durch Mischen von Aluminium-, Yttrium-und Cer-haltigen Edukten mit mindestens einem Sb, Bi und/oder Th-haltigen Co-Dotierstoff nach nasschemischen Methoden und anschließender thermischer Nachbehandlung.

7. Verfahren zur Herstellung eines Leuchtstoffes mit Granatstruktur der Formel II bis IV mit folgenden Verfahrensschritten:
a) Herstellen eines Cer-aktivierten Leuchtstoffes, der mit Antimon-, Bismut- und/oder Thorium-haltigen Materialien co-dotiert wird, aus Leuchtstoffprecursor-Suspensionen oder Lösungen durch Mischen von mindestens drei Edukten ausgewählt aus Y-, Al- und Ce-haltigen Materialien nach nasschemischen Methoden
b) Thermische Nachbehandlung des mit Antimon, Bismut und/oder Thorium co-dotierten Leuchtstoffes.

8. Verfahren nach Anspruch 7, **dadurch gekennzeichnet, dass** im Schritt a) der Leuchtstoffprecursor nasschemisch aus organischen und/oder anorganischen Metall- und/oder Seltenerd-Salzen mittels Sol-Gel-Verfahren, Präzipitationsverfahren und/oder Trocknungsverfahren, vorzugsweise Sprühtrocknung, hergestellt wird.

9. Verfahren nach Anspruch 7 und/oder 8, **dadurch gekennzeichnet, dass** die Oberfläche des Leuchtstoffes mit Nanopartikeln aus SiO₂, TiO₂, Al₂O₃, ZnO, ZrO₂ und/oder Y₂O₃ oder Mischoxide daraus oder mit Nanopartikeln aus der Leuchtstoffzusammensetzung beschichtet wird.

10. Verfahren nach Anspruch 7 und/oder 8, **dadurch gekennzeichnet, dass** die Oberfläche des Leuchtstoffes mit einer geschlossenen Beschichtung aus SiO₂, TiO₂, Al₂O₃, ZnO, ZrO₂ und/oder Y₂O₃ oder Mischoxide daraus versehen wird.

11. Verfahren nach Anspruch 7 und/oder 8, **dadurch gekennzeichnet, dass** die Oberfläche des Leuchtstoffes mit einer porösen Beschichtung aus SiO₂, TiO₂, Al₂O₃, ZnO, ZrO₂ und/oder Y₂O₃ oder Mischoxide daraus oder aus der Leuchtstoffzusammensetzung versehen wird.

12. Beleuchtungseinheit mit mindestens einer Primärlichtquelle, deren Emissionsmaximum im Bereich 410 nm bis 530 nm liegt, vorzugsweise zwischen 430 nm und 500 nm, wobei diese Strahlung teilweise oder vollständig in längerwellige Strahlung konvertiert wird durch einen Leuchtstoff nach einem oder mehreren der Ansprüche 1 bis 6.

13. Beleuchtungseinheit nach Anspruch 12, **dadurch gekennzeichnet, dass** es sich bei der Primärlichtquelle um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 handelt.

14. Beleuchtungseinheit nach Anspruch 12, **dadurch gekennzeichnet, dass** es bei der Primärlichtquelle um eine lumineszente auf ZnO, TCO (Transparent conducting oxide), ZnSe oder SiC basierende Verbindung handelt.

15. Beleuchtungseinheit nach Anspruch 12, **dadurch gekennzeichnet, dass** es sich bei der Primärlichtquelle um eine auf einer organischen lichtemittierenden Schicht basierendes Material handelt.

16. Beleuchtungseinheit nach Anspruch 12, **dadurch gekennzeichnet, dass** es sich bei der Primärlichtquelle um eine Quelle handelt, die Elektrolumineszenz und/oder Photolumineszenz zeigt.

17. Beleuchtungseinheit nach Anspruch 12, **dadurch gekennzeichnet, dass** es sich bei der Primärlichtquelle um eine Plasma- oder Entladungsquelle handelt.

18. Beleuchtungseinheit nach einem oder mehreren der Ansprüche 12 bis 17, **dadurch gekennzeichnet, dass** der Leuchtstoff direkt auf der Primärlichtquelle und/oder von dieser entfernt angeordnet ist.

19. Beleuchtungseinheit nach einem oder mehreren der Ansprüche 12 bis 18, **dadurch gekennzeichnet, dass** die optische Ankopplung zwischen dem Leuchtstoff und der Primärlichtquelle durch eine lichtleitende Anordnung realisiert ist.

20. Verwendung von mindestens einem Leuchtstoff nach einem oder mehreren der Ansprüche 1 bis 6 als Konversions-leuchtstoff zur teilweisen oder vollständigen Konversion der blauen oder im nahen UV-liegenden Emission einer Lumineszenzdiode.

21. Verwendung von mindestens einem Leuchtstoff nach einem oder mehreren der Ansprüche 1 bis 6 als Konversions-leuchtstoff zur Konversion der Primärstrahlung in einen bestimmten Farbpunkt nach dem Color-on-demand-Konzept.

22. Verwendung von mindestens einem Leuchtstoff nach einem oder mehreren der Ansprüche 1 bis 6 zur Konversion der blauen oder im nahen UV-liegenden Emission in sichtbare weiße Strahlung.

## Claims

1. Phosphor having a garnet structure, **characterised in that** it is a compound selected from the compounds having the formulae II to IV:
(Y_{1-x-y}CeₓSb_{y})₃Al₅O₁₂ where 0.005 ≤ x ≤ 0.1 and 0.001 ≤ y ≤ 0.005 (II)
(Y_{1-x-y}CeₓBi_{y})₃Al₅O₁₂ where 0.005 ≤ x ≤ 0.1 and 0.001 ≤ y ≤ 0.005 (III)
(Y_{1-x-y}CeₓTh_{y})₃Al₅O₁₂ where 0.005 ≤ x ≤ 0.1 and 0.001 ≤ y ≤ 0.005 (IV)

2. Phosphor according to Claim 1, **characterised in that** it has a surface which carries nanoparticles of SiO₂, TiO₂, Al₂O₃, ZnO, ZrO₂ and/or Y₂O₃ or mixed oxides thereof or particles comprising the phosphor composition.

3. Phosphor according to Claim 1 or 2, **characterised in that** it has a continuous surface coating which consists of SiO₂, TiO₂, Al₂O₃, ZnO, ZrO₂ and/or Y₂O₃ or mixed oxides thereof.

4. Phosphor according to one or more of Claims 1 to 3, **characterised in that** it has a porous surface coating which consists of SiO₂, TiO₂, Al₂O₃, ZnO, ZrO₂ and/or Y₂O₃ or mixed oxides thereof or of the phosphor composition.

5. Phosphor according to one or more of Claims 1 to 4, **characterised in that** the surface carries functional groups which facilitate chemical bonding to the environment, preferably consisting of epoxy or silicone resin.

6. Phosphor according to one or more of Claims 1 to 5, obtainable by mixing aluminium-, yttrium- and cerium-containing starting materials with at least one Sb-, Bi- and/or Th-containing co-dopant by wet-chemical methods and subsequent thermal aftertreatment.

7. Process for the preparation of a phosphor having a garnet structure of the formulae II to IV, having the following process steps:
a) preparation of a cerium-activated phosphor which is co-doped with antimony-, bismuth- and/or thorium-containing materials from phosphor precursor suspensions or solutions by mixing at least three starting materials selected from Y-, Al- and Ce-containing materials by wet-chemical methods,
b) thermal aftertreatment of the phosphor co-doped with antimony, bismuth and/or thorium.

8. Process according to Claim 7, **characterised in that** the phosphor precursor is prepared in step a) by wet-chemical methods from organic and/or inorganic metal and/or rare-earth salts by means of a sol-gel method, precipitation method and/or drying method, preferably spray drying.

9. Process according to Claim 7 and/or 8, **characterised in that** the surface of the phosphor is coated with nanoparticles of SiO₂, TiO₂, Al₂O₃, ZnO, ZrO₂ and/or Y₂O₃ or mixed oxides thereof or with nanoparticles of the phosphor composition.

10. Process according to Claim 7 and/or 8, **characterised in that** the surface of the phosphor is provided with a continuous coating of SiO₂, TiO₂, Al₂O₃, ZnO, ZrO₂ and/or Y₂O₃ or mixed oxides thereof.

11. Process according to Claim 7 and/or 8, **characterised in that** the surface of the phosphor is provided with a porous coating of SiO₂, TiO₂, Al₂O₃, ZnO, ZrO₂ and/or Y₂O₃ or mixed oxides thereof or of the phosphor composition.

12. Lighting unit having at least one primary light source whose emission maximum is in the range 410 nm to 530 nm, preferably between 430 nm and 500 nm, where this radiation is partially or fully converted into longer-wavelength radiation by a phosphor according to one or more of Claims 1 to 6.

13. Lighting unit according to Claim 12, **characterised in that** the primary light source is a luminescent indium aluminium gallium nitride, in particular of the formula InᵢGaⱼAlₖN, where 0 ≤ i, 0 ≤ j, 0 ≤ k, and i+j+k=1.

14. Lighting unit according to Claim 12, **characterised in that** the primary light source is a luminescent compound based on ZnO, TCO (transparent conducting oxide), ZnSe or SiC.

15. Lighting unit according to Claim 12, **characterised in that** the primary light source is a material based on an organic light-emitting layer.

16. Lighting unit according to Claim 12, **characterised in that** the primary light source is a source which exhibits electroluminescence and/or photoluminescence.

17. Lighting unit according to Claim 12, **characterised in that** the primary light source is a plasma or discharge source.

18. Lighting unit according to one or more of Claims 12 to 17, **characterised in that** the phosphor is arranged directly on the primary light source and/or remote therefrom.

19. Lighting unit according to one or more of Claims 12 to 18, **characterised in that** the optical coupling between the phosphor and the primary light source is achieved by means of a light-conducting arrangement.

20. Use of at least one phosphor according to one or more of Claims 1 to 6 as conversion phosphor for partial or complete conversion of the blue or near-UV emission from a luminescent diode.

21. Use of at least one phosphor according to one or more of Claims 1 to 6 as conversion phosphor for conversion of the primary radiation into a certain colour point by the colour-on-demand concept.

22. Use of at least one phosphor according to one or more of Claims 1 to 6 for conversion of the blue or near-UV emission into visible white radiation.

## Revendications

1. Phosphore présentant une structure de grenat, **caractérisé en ce qu'**il est un composé choisi parmi les composés présentant les formules Il à IV:
(Y_{1-x-y}CeₓSb_{y})₃Al₅O₁₂ où 0,005 ≤ x ≤ 0,1 et 0,001 ≤ y ≤ 0,005 (II)
(Y_{1-x-y}CeₓBi_{y})₃Al₅O₁₂ où 0,005 ≤ x ≤ 0,1 et 0,001 ≤ y ≤ 0,005 (III)
(Y_{1-x-y}CeₓTh_{y})₃Al₅O₁₂ où 0,005 ≤ x ≤ 0,1 et 0,001 ≤ y ≤ 0,005 (IV)

2. Phosphore selon la revendication 1, **caractérisé en ce qu'**il comporte une surface qui est porteuse de nanoparticules de SiO₂, TiO₂, Al₂O₃, ZnO, ZrO₂ et/ou Y₂O₃ ou d'oxydes mélangés afférents ou de particules comprenant la composition de phosphore.

3. Phosphore selon la revendication 1 ou 2 **caractérisé en ce qu'**il comporte un revêtement de surface continu qui est constitué par SiO₂, TiO₂, Al₂O₃, ZnO, ZrO₂ et/ou Y₂O₃ ou des oxydes mélangés afférents.

4. Phosphore selon une ou plusieurs des revendications 1 à 3, **caractérisé en ce qu'**il comporte un revêtement de surface poreux qui est constitué par SiO₂, TiO₂, Al₂O₃, ZnO, ZrO₂ et/ou Y₂O₃ ou des oxydes mélangés afférents ou par la composition de phosphore.

5. Phosphore selon une ou plusieurs des revendications 1 à 4, **caractérisé en ce que** la surface est porteuse de groupes fonctionnels qui facilitent une liaison chimique à l'environnement, de préférence constitués par une résine époxy ou silicone.

6. Phosphore selon une ou plusieurs des revendications 1 à 5, pouvant être obtenu en mélangeant des matériaux de départ contenant de l'aluminium, de l'yttrium et du cérium avec au moins un co-dopant contenant du Sb, du Bi et/ou du Th au moyen de procédés chimiques par voie humide et d'un post-traitement final qui suit.

7. Procédé pour la préparation d'un phosphore présentant une structure de grenat des formules II à IV, comportant les étapes de processus qui suivent :
a) préparation d'un phosphore activé par cérium, lequel est co-dopé avec des matériaux contenant de l'antimoine, du bismuth et/ou du thorium à partir de suspensions ou de solutions précurseuses de phosphore en mélangeant au moins trois matériaux de départ choisis parmi des matériaux contenant de l'Y, de l'Al et du Ce au moyen de procédés chimiques par voie humide,
b) post-traitement thermique du phosphore co-dopé avec de l'antimoine, du bismuth et/ou du thorium.

8. Procédé selon la revendication 7, **caractérisé en ce que** le précurseur de phosphore est préparé au niveau de l'étape a) au moyen de procédés chimiques par voie humide à partir de sels métalliques et/ou de terre rare organiques et/ou inorganiques au moyen d'un procédé sol-gel, d'un procédé de précipitation et/ou d'un procédé de séchage, de préférence un séchage par pulvérisation.

9. Procédé selon la revendication 7 et/ou 8, **caractérisé en ce que** la surface du phosphore est revêtue de nanoparticules de SiO₂, TiO₂, Al₂O₃, ZnO, ZrO₂ et/ou Y₂O₃ ou d'oxydes mélangés afférents ou de nanoparticules de la composition de phosphore.

10. Procédé selon la revendication 7 et/ou 8, **caractérisé en ce que** la surface du phosphore est munie d'un revêtement continu de SiO₂, TiO₂, Al₂O₃, ZnO, ZrO₂ et/ou Y₂O₃ ou d'oxydes mélangés afférents.

11. Procédé selon la revendication 7 et/ou 8, **caractérisé en ce que** la surface du phosphore est munie d'un revêtement poreux de SiO₂, TiO₂, Al₂O₃, ZnO, ZrO₂ et/ou Y₂O₃ ou d'oxydes mélangés afférents ou de la composition de phosphore.

12. Unité d'éclairage comportant au moins une source de lumière primaire dont un maximum d'émission est dans la plage de 410 nm à 530 nm, de préférence entre 430 nm et 500 nm, dans laquelle ce rayonnement est partiellement ou complètement converti selon un rayonnement de longueurs d'onde plus longues au moyen d'un phosphore selon une ou plusieurs des revendications 1 à 6.

13. Unité d'éclairage selon la revendication 12, **caractérisée en ce que** la source de lumière primaire est un nitrure d'indium-aluminium-gallium luminescent, en particulier de la formule InᵢGaⱼAlₖN, où 0 ≤ i, 0 ≤ j, 0 ≤ k, et i+j+k=1.

14. Unité d'éclairage selon la revendication 12, **caractérisée en ce que** la source de lumière primaire est un composé luminescent basé sur ZnO, TCO (oxyde conducteur transparent), ZnSe ou SiC.

15. Unité d'éclairage selon la revendication 12, **caractérisée en ce que** la source de lumière primaire est un matériau basé sur une couche émettrice de lumière organique.

16. Unité d'éclairage selon la revendication 12, **caractérisée en ce que** la source de lumière primaire est une source qui présente une électroluminescence et/ou une photoluminescence.

17. Unité d'éclairage selon la revendication 12, **caractérisée en ce que** la source de lumière primaire est une source par plasma ou décharge.

18. Unité d'éclairage selon une ou plusieurs des revendications 12 à 17, **caractérisée en ce que** le phosphore est agencé directement sur la source de lumière primaire et/ou à distance de celle-ci.

19. Unité d'éclairage selon une ou plusieurs des revendications 12 à 18, **caractérisée en ce que** le couplage optique entre le phosphore et la source de lumière primaire est réalisé au moyen d'un agencement conducteur de lumière.

20. Utilisation d'au moins un phosphore selon une ou plusieurs des revendications 1 à 6 en tant que phosphore de conversion pour une conversion partielle ou complète d'une émission de bleu ou d'UV proche en provenance d'une diode luminescente.

21. Utilisation d'au moins un phosphore selon une ou plusieurs des revendications 1 à 6 en tant que phosphore de conversion pour une conversion du rayonnement primaire selon un certain point de couleur au moyen du concept couleur à la demande.

22. Utilisation d'au moins un phosphore selon une ou plusieurs des revendications 1 à 6 pour une conversion de l'émission de bleu ou d'UV proche selon un rayonnement blanc visible.
